Europäisches Patentamt

European Patent Office

Office européen des brevets

(11) Publication number: **0 186 423**
A2

# (12) EUROPEAN PATENT APPLICATION

(21) Application number: 85309207.0

(22) Date of filing: 17.12.85

(51) Int. Cl.⁴: **B 60 L 7/28**
B 66 F 9/075

(30) Priority: 21.12.84 GB 8432431

(43) Date of publication of application:
02.07.86 Bulletin 86/27

(84) Designated Contracting States:
GB NL SE

(71) Applicant: LANCER BOSS GROUP LIMITED
Grovebury Road
Leighton Buzzard Bedfordshire LU7 8SR(GB)

(72) Inventor: Mogano, Adrian Douglas
10 Underwood Crescent
Sapcote Leicester LE9 6FY(GB)

(74) Representative: Richards, David John et al,
Page, White & Farrer 5, Plough Place New Fetter Lane
London EC4A 1HY(GB)

(54) Lift-truck.

(57) A lift-truck is provided with an electromagnetic retarder (1) coupled in its drive train so that an electromagnetic braking effect may be applied thereto. The retarder may be mounted on the gearbox (2), in the propellor shaft (4), or on an axle (3) of the vehicle. The retarder may be operated by a hand lever (8) or may be connected to the brake pedal or accelerator pedal of the lift-truck.

FIG.4.

Lift-Truck

The invention relates to lift-trucks for load handling.  Such trucks are normally fitted with lifting forks on which a load is raised and transported.

Very substantial loads may be carried by such trucks and the size of these loads when added to the weight of the truck can provide a formidable braking problem.  This position is particularly exacerbated in so called roll-on/roll-off operations for loading and unloading cargo carrying vessels.  In these operations the trucks will continuously carry heavy loads up and down a relatively steep ramp. The braking need during such operations is extremely high and the wear on conventional braking systems and the need for servicing and replacement are correspondingly increased.

The present invention provides a lift-truck wherein the problems caused by heavy braking during such operations are overcome.

According to the present invention there is provided a lift-truck having means such as forks on which a load may be raised and transported, the lift-truck comprising a drive train connected between a prime mover and at least one pair of drive wheels wherein electromagnetic retarder is coupled in the drive train whereby an electromagnetic braking effect may be selectively applied to the drive train.

The drive train of the lift-truck may take any suitable form and will normally comprise a gearbox connected via propellor shafts to an axle mounted differential; the drive wheels being located at opposite ends of the axle.  In many cases the drive wheels of lift-trucks are dirigible and in this case the wheels will be coupled to the drive train through universal joints.

The position of the electromagnetic retarder in the drive train will be selected according to convenience and cost and it may suitably be provided mounted on the gearbox, mounted between propellor shafts, or mounted on the axle. If the axle incorporates a differential drive the retarder may be mounted directly thereon.

Operation of the electromagnetic retarder may be governed by manual operation of a control lever and/or by the operation of a brake sensor.

Advantageously a speed sensitive cut out device may be fitted to disconnect the electromagnetic retarder at vehicle speeds below a predetermined minimum so as to prevent overheating of the retarder through prolonged operation when the vehicle is stationery.

A detailed desciption of embodiments of the present invention is given below with reference to the accompanying drawings in which:

Figure 1 shows diagrammatically the drive train of a lift-truck with a retarder completed therein,

Figure 2 shows an alternative to the arrangement in Figure 1,

Figure 3 shows a further alternative, and

Figure 4 is a box-diagram showing the operation and control of the retarder.

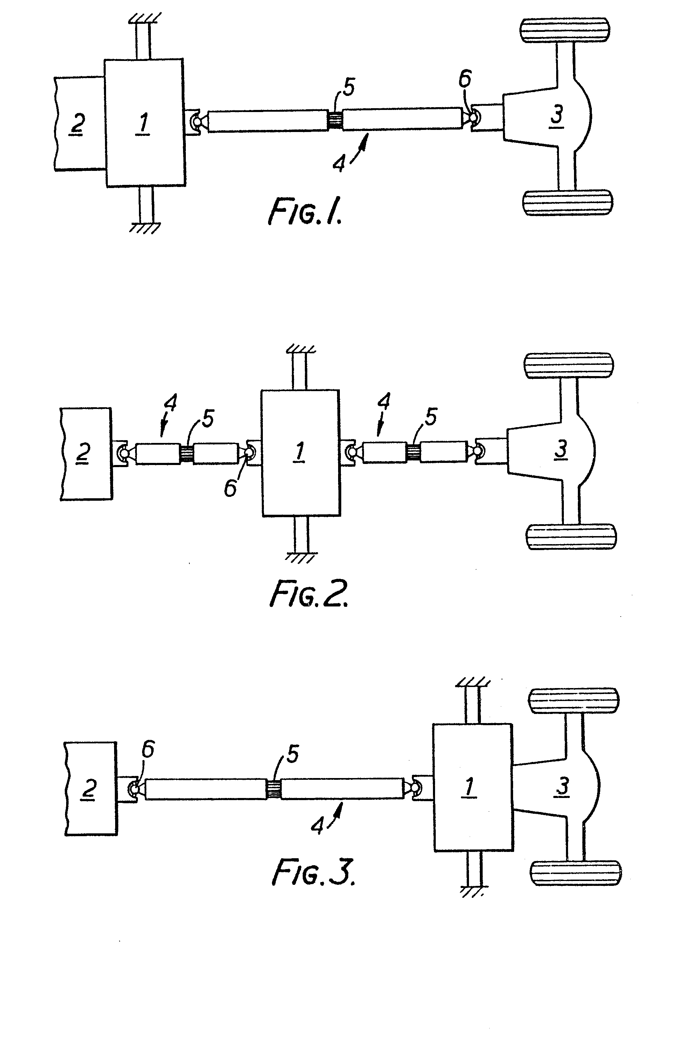

Three possible arrangements of the retarder in a drive train are shown in Figures 1 to 3. In Figure 1 the retarder 1 is connected directly onto the output shaft of the gearbox 2 and is coupled to a drive axle 3 by means of a propellor shaft 4. The propellor shaft may have splined couplings 5 and universal couplings 6 to allow for movement of the different parts of the drive train relative to the chassis of the truck.

In Figure 2 the retarder is mounted in the propellor shaft 4.

In Figure 3 the retarder is mounted on the axle 3.

In each case the retarder will be connected to the frame or chassis of the vehicle so that the non-rotating parts of the retarder may be held stationary.

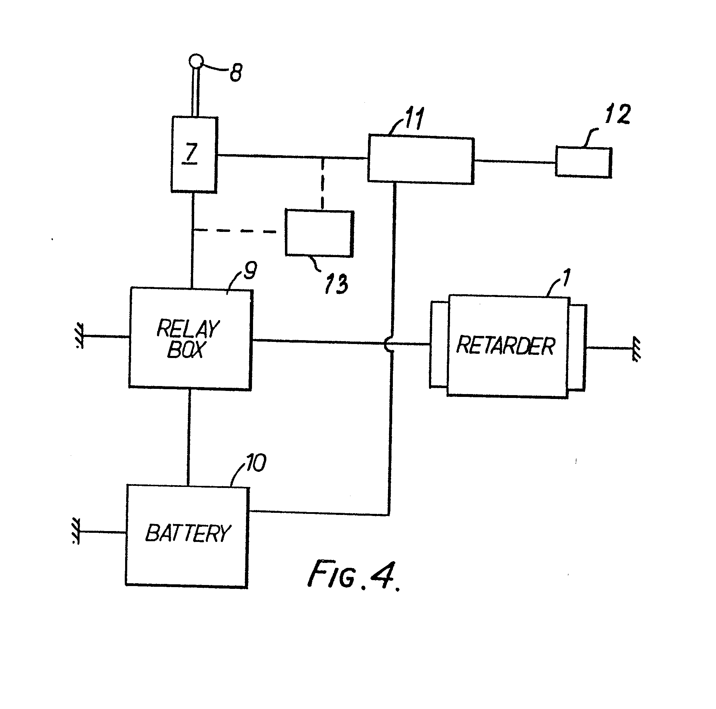

Figure 4 shows, diagrammatically, how the retarder is brought into operation. A battery 10 which may suitably be a 12 or 24 volt battery is coupled via a relay box 9 to the coils of the electromagnetic retarder. In one example, the retarder is provided with eight coils arranged around its axis, and the coils are coupled in pairs to the battery 10 via four relays in the relay box 9. The number of coils energised at any one time via the relay box will be dependent of the operation of a control system 7 comprising a manually operated lever 8. In the example described the lever 8 has five different possible positions; in a first position none of the relays in the relay box is energised, and consequently none of the coils of the retarder are connected to the battery. In this "off" position the retarder applies no electromagnetic braking effect to the drive train. The other four positions of the lever 8 correspond to the progressive braking modes of the retarder wherein two, four, six, or all eight of the coils are energised by the battery.

In the embodiment shown, a speed sensitive cut-out device 11 is fitted to prevent overheating of the retarder through prolonged

0186423

operation when the vehicle is stationary. This removes the control signal to the retarder at vehicle speeds below a predetermined minimum, eg 1 kph. Motion may be sensed from rotation of propshaft, out-put of transmission or wheel rotation, by a motion sensor 12, connected to a cut-out device 11.

The motion sensor may be a magnetic switch, a proximity device, an optical switch, or a power generator.

A controller in the cut-out device senses the strength of the signal from the sensor 11 and switches the retarder operating relays accordingly.

In an alternative embodiment, shown in dotted lines in Figure 4, the relay box may be operated by a brake sensor 13 coupled to the foot brake lever of the lift truck such that over the initial travel of the lever before the conventional brakes are engaged, the retarder is progressively introduced to provide smooth braking. Although shown as alternative, the brake sensor may be provided in addition to the control system 7.

In yet another embodiment, not shown, the control system 7 is coupled to the accelerator pedal of the lift truck such that the retarder is automatically brought into operation when the pedal is released.

The main parts of the retarder are a shaft, coils, stator and a pair of vaned cooling rotors. None of these parts are shown in the accompanying drawings in which the retarder is shown only schematically.

## CLAIMS

1.    A lift-truck having means such as forks on which a load may be raised and transported, the lift-truck comprising a drive train connected between a prime mover and at least one pair of drive wheels characterised in that an electromagnetic retarder is coupled in the drive train whereby an electromagnetic braking effect may be selectively applied to the drive train.

2.    A lift-truck according to Claim 1, wherein the drive train comprises a gearbox, at least one propellor shaft, and an axle, and wherein the electromagnetic retarder is mounted on the gearbox.

3.    A lift-truck according to Claim 1, wherein the drive train comprises a gearbox, at least one propellor shaft, and an axle, and wherein the electromagnetic retarder is mounted in the propellor shaft.

4.    A lift-truck according to Claim 1, wherein the drive train comprises a gearbox, at least one propellor shaft, and an axle, and wherein the electromagnetic retarder is mounted on the axle.

5.    A lift-truck according to any preceding claim, wherein the braking effect of the electromagnetic retarder is governed by a manually operated control lever.

6.    A lift-truck according to any of Claims 1 - 5, wherein the braking effect of the electromagnetic retarder is governed by operation of a brake sensor coupled to of the pedal by which the conventional braking system of the lift-truck is also operated.

7.    A lift-truck according to any of Claims 1 to 4, wherein the braking effect of the electromagnetic retarder is governed by operation of the accelerator pedal of the lift-truck.

8.    A lift truck according to any preceding claim wherein a speed sensitive cut-out device is fitted to cut out the electromagnetic retarder at vehicle speeds below a predetermined minimum to prevent overheating of the retarder through prolonged operation when the vehicle is stationery.

9.    A lift-truck according to any preceding claim comprising a generally rectangular chassis with at least one wheel located adjacent each corner thereof and a load handling carriage mounted at one end of the chassis, wherein the wheels at the end of the chassis adjacent the carriage are driven, and the wheels at the other end are dirigible.

FIG.1.

FIG.2.

FIG.3.

FIG.4.